# EUROPÄISCHE PATENTANMELDUNG

(11) **EP 0 887 862 A2**
(43) Veröffentlichungstag der Anmeldung: **30.12.1998**
(21) Anmeldenummer: 98105811.8
(22) Anmeldetag: 30.03.1998
(51) Int. Cl.: H01L 27/108, H01L 21/8242

(54) **DRAM mit selbstverstärkenden Speicherzellen**

(30) Priorität: 27.06.1997 DE 19727436
(71) Anmelder: SIEMENS AKTIENGESELLSCHAFT, 80333 München (DE)
(72) Erfinder: Krautschneider, Wolfgang, Dr., 83104 Hohenthann (DE); Hofmann, Franz, Dr., 80995 München (DE)

(57) **Zusammenfassung**

DRAM-Zellenanordnung mit dynamischen selbstverstärkenden Speicherzellen und Verfahren zu deren Herstellung.

In einer selbstverstärkenden dynamischen Speicherzellenanordnung weist jede Speicherzelle einen Auswahltransistor, einen Speichertransistor und eine Diodenstruktur auf. Auswahltransistor und Speichertransistor sind jeweils als vertikale MOS-Transistoren ausgebildet und übereinander angeordnet. Sie sind über ein gemeinsames Source-/Drain-Gebiet (7') miteinander verbunden. Ein Source-/Drain-Gebiet (2) des Speichertransistors ist mit einer Versorgungsspannungsleitung, ein Source-/Drain-Gebiet (5') des Auswahltransistors mit einer Bitleitung, die Gateelektrode (19) des Auswahltransistors mit einer Wortleitung verbunden. Zwischen das gemeinsame Source-/Drain-Gebiet (7') und die Gateelektrode (11) des Speichertransistors ist eine Diodenstruktur (11, 12, 14) geschaltet.

## Beschreibung

DRAM-Zellenanordnung mit dynamischen selbstverstärkenden Speicherzellen und Verfahren zu deren Herstellung.

Mit zunehmender Speicherdichte pro Chip von einer Speichergeneration zur nächsten ist die Fläche dynamischer Halbleiterspeicherzellen ständig verkleinert worden. Dazu sind ab der 4Mbit-Speichergeneration dreidimensionale Strukturen erforderlich. Ab der 64 Mbit-Speichergeneration hat die Speicherkapazität einen Wert erreicht, der sich kaum noch reduzieren läßt, so daß eine ungefähr konstante Kapazität auf einer verkleinerten Zellfläche realisiert werden muß. Dies fuhrt zu einem erheblichen technologischen Aufwand.

In Speicherzellen, bei denen die Signalladung nicht von einem Speicherkondensator sondern von einer Versorgungsspannungsquelle geliefert wird, wird dagegen die Hohe der Signalladung nicht von der Größe der Speicherkapazität bestimmt. Bei diesen Speicherzellen ist es ausreichend, im Speicherkondensator nur eine kleinere Ladung zu speichern, die beim Auslesen der Speicherzelle ein Schaltelement so aktiviert, daß eine leitende Verbindung zwischen der Versorgungsspannungsquelle und einer Bitleitung hergestellt wird. Derartige Speicherzellen werden als selbstverstärkende Speicherzellen oder Gain Memory Cells bezeichnet.

Eine derartige selbstverstärkende Speicherzelle ist zum Beispiel in M. Terauchi, A. Nitayama, F. Horiguchi und F. Masuoka, 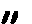 A surrounding gate transistor (SGT) gain cell for ultra high density DRAMS", VLSI-Symp. Dig. Techn. Pap. p. 21, 1993, vorgeschlagen worden. Sie umfaßt einen eine Siliziumsäule umgebenden MOS-Transistor und einen darunter angeordneten Junction-Feldeffekttransistor. Der MOS-Transistor wirkt als Einschreibetransistor, während der Junction-Feldeffekttransistor als Auslesetransistor wirkt. Zum Auslesen und zum Einschreiben von Informationen sind in dieser Speicherzelle zwei getrennte Wortleitungen erforderlich, so daß zu jeder Speicherzelle zwei Wortleitungen vorgesehen sind.

In S. Shukuri, T. Kure, T. Kobayashi, Y. Gotoh und T. Nishida, 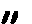 A semistatic complementary gain cell technology for sub-1 V supply DRAM's", IEEE Trans. Electron Dev., vol. 41, p. 926, 1994, ist eine selbstverstärkende Speicherzelle vorgeschlagen worden, die einen planaren MOS-Transistor und einen dazu komplementären, in einem Graben angeordneten Dünnfilmtransistor umfaßt. Der planare MOS-Transistor dient zum Einschreiben von Informationen, der Dünnfilmtransistor zum Auslesen von Informationen. Der Dünnfilmtransistor umfaßt ein floatendes Gate, das beim Einschreiben von Informationen mit Ladung beaufschlagt wird. Die Gateelektroden beider MOS-Transistoren sind mit einer Wortleitung verbunden. Sie werden mit unterschiedlicher Polarität angesteuert, so daß das Erzeugen und Schalten von Wortleitungsspannungen mit einem schaltungstechnischen Aufwand verbunden ist.

Aus WO 92/01287 ist eine selbstverstärkende dynamische MOS-Transistorspeicherzelle bekannt, die einen Auswahltransistor und einen Speichertransistor umfaßt. In dieser Speicherzelle wird die Ladung in der Gate/Source-Kapazität des Speichertransistors gespeichert. Die beiden Transistoren sind in Reihe geschaltet und weisen ein gemeinsames Drain/Source-Gebiet auf. Dieses gemeinsame Drain/Source-Gebiet ist über eine Diodenstruktur mit der Gateelektrode des Speichertransistors verbunden. Beim Auslesen wird der Speichertransistor je nach eingespeicherter Information eingeschaltet und schließt dadurch einen Strompfad von einer Versorgungsspannung zu einer Bitleitung. In diesem Zelltyp sind Auswahl- und Speichertransistor in Reihe geschaltet, so daß zum Aulesen des Signals keine spezielle Leitung erforderlich ist. Auswahltransistor und Speichertransistor können dabei sowohl als planare MOS-Transistoren als auch als vertikale MOS-Transistoren, die jeweils entlang der Flanke eines Grabens angeordnet sind, realisiert werden.

Der Erfindung liegt das Problem zugrunde, eine DRAM-Zellenanordnung mit dynamischen selbstverstärkenden Speicherzellen sowie ein Verfahren zu deren Herstellung anzugeben, die mit hoher Packungsdichte und verbesserten elektrischen Eigenschaften herstellbar ist.

Dieses Problem wird erfindungsgemäß gelöst durch eine DRAM-Zellenanordnung gemäß Anspruch 1 sowie durch ein Verfahren zu deren Herstellung gemäß Anspruch 6. Weitere Ausgestaltungen der Erfindung gehen aus den übrigen Ansprüchen hervor. In der erfindungsgemäßen DRAM-Zellenanordnung wird die Packungsdichte dadurch erhöht, daß Auswahltransistor und Speichertransistor der selbstverstärkenden Speicherzellen jeweils als in Bezug auf eine Hauptfläche eines Substrats vertikale MOS-Transistoren ausgebildet sind. Dabei sind der Auswahltransistor und der Speichertransistor übereinander angeordnet und über ein gemeinsames Source-/Drain-Gebiet miteinander verbunden. Im Vergleich zu den bekannten Anordnungen läßt sich dadurch ein Faktor 2 in der Packungsdichte gewinnen.

Die vertikalen MOS-Transistoren können sowohl an der Flanke eines Grabens als auch an den Flanken von erhabenen Strukturen, zum Beispiel Säulen, angeordnet sein.

Ein Source-/Drain-Gebiet des Speichertransistors ist mit einer Versorgungsspannungsleitung, ein Source-/Drain-Gebiet des Auswahltransistors mit einer Bitleitung und die Gateelektrode des Auswahltransistors mit einer Wortleitung verbunden. Zwischen das gemeinsame Source-/Drain-Gebiet und die Gateelektrode des Speichertransistors ist eine Diodenstruktur geschaltet.

Vorzugsweise weist das Substrat Säulen auf, die senkrecht zur Hauptfläche des Substrats angeordnet sind. Der Auswahltransistor und der Speichertransistor einer Speicherzelle sind jeweils an den Flanken einer der Säulen angeordnet, wobei die Gateelektroden des Auswahltransistors und des Speichertransistors sowie die Diodenstruktur die Säule ringförmig umgeben. Da die Gateelektroden die Säulen jeweils ringförmig umgeben, verläuft der Kanal über die ringförmige Oberfläche der Säule. Im Vergleich zu einem planaren MOS-Transistor, der mit derselben Strukturfeinheit hergestellt wird wie die Säulen, weisen der Auswahltransistor und der Speichertransistor in dieser Ausführungsform eine um einen Faktor 4 größere Kanalweite auf. Dadurch wird in dieser Ausführungsform nicht nur eine höhere Packungsdichte sondern auch eine höhere Stromtragfähigkeit des Auswahl- und des Speichertransistors erzielt. Durch diese erhöhte Stromtragfähigkeit des Auswahltransistors und des Speichertransistors kann beim Auslesen der Speicherzellen ein höheres Signal, das aufgrund der Verbindung des Source-/Drain-Gebietes des Speichertransistors mit der Versorgungsspannungsleitung zur Verfügung steht, an der Bitleitung abgegriffen werden.

Vorzugsweise verläuft die Versorgungsspannungsleitung mindestens teilweise im Substrat unterhalb der Säulen. Die Versorgungsspannungsleitung kann dabei sowohl als durchgehende Platte für alle Speicherzellen gemeinsam als auch als gitterförmige Platte oder als Vielzahl parallel verlaufender streifenförmiger Leitungen ausgebildet sein.

Die Ausbildung der Versorgungsspannungsleitung als durchgehende Platte hat den Vorzug einer vereinfachten Herstellbarkeit.

Die Ausbildung der Versorgungsspannungsleitung als gitterförmige Platte hat den Vorteil, daß das Material der Säule mit dem Substratpotential bzw. dem Potential einer dotierten Wanne, die an die Säulen angrenzt, beaufschlagt werden kann. Auf diese Weise werden Floating body-Effekte vermieden.

Die Ausbildung der Versorgungsspannungsleitung in Form von diskreten, parallel verlaufenden Leitungen hat den Vorteil, daß die Speicherzellen über diese diskreten Versorgungsspannungsleitungen bewertet werden können.

Es liegt im Rahmen der Erfindung, die Diodenstruktur als NP-Diode und/oder Schottky-Diode auszubilden.

Eine weitere Möglichkeit besteht darin, diese Diodenstruktur als Dünnschichtdiode im Sinne eines Dünnfilmbauelementes mit einem dielektrischen Film von ca. 1 bis 2 nm Dicke, um direktes Tunneln zu ermöglichen, herzustellen. Dieser dielektrische Film befindet sich zwischen zwei unterschiedlich dotierten, halbleitenden Schichten aus zum Beispiel polykristallinem Silizium.

Vorzugsweise wird zwischen den Diodenstrukturen benachbarter Säulen eine zusätzliche leitende Struktur angeordnet, die gemeinsam mit der daran angrenzenden Oberfläche der Diodenstruktur eine zusätzliche Kapazität bildet.

Vorzugsweise wird die Speicherzellenanordnung durch Einsatz selbstjustierender Prozeßschritte hergestellt. Zur Bildung der Säulen werden zunächst erste und zweite Gräben geätzt, wobei sowohl die ersten Gräben als auch die zweiten Gräben streifenförmig sind und im wesentlichen parallel zueinander verlaufen und die ersten Gräben die zweiten Gräben kreuzen. Dadurch sind die Säulen mit einer Kantenlänge von einer in der jeweiligen Technologie minimal herstellbaren Strukturgröße F und einem Abstand von einer minimal herstellbaren Strukturgröße F herstellbar. Auf diese Weise läßt sich ein Platzbedarf pro Speicherzelle von 4F² erzielen.

Vorzugsweise werden zur Bildung der Säulen zunächst erste und zweite Teilgräben geätzt, deren Verlauf dem der ersten und zweiten Gräben entspricht und deren Tiefe geringer als die der ersten und zweiten Gräben ist. Abschließend wird ein dotiertes Gebiet am Boden der ersten und zweiten Teilgräben gebildet. Durch weiteres Ätzen werden aus den ersten und zweiten Teilgräben die ersten und zweiten Gräben erzeugt. Dabei wird durch Strukturieren des dotierten Gebietes am Boden der ersten und zweiten Teilgräben jeweils das gemeinsame Source-/Drain-Gebiet erzeugt. Das gemeinsame Source-/Drain-Gebiet ist ringförmig in der Flanke der jeweiligen Säule angeordnet. Das dotierte Gebiet kann sowohl durch Implantation als auch durch Ausdiffusion aus einer Dotierstoffquelle, zum Beispiel aus dotiertem Glas, gebildet werden.

Die Versorgungsspannungsleitung kann, falls sie in Form einer durchgehenden Platte realisiert wird, vor der Bildung der Säulen,erzeugt werden. Falls sie in Form einer gitterförmigen Platte realisiert wird, wird die Versorgungsspannungsleitung nach der Bildung der Säulen am Boden der ersten und zweiten Gräben als dotiertes Gebiet erzeugt.

Zur Bildung diskreter Versorgungsspannungsleitungen liegt es im Rahmen der Erfindung, zunächst die ersten Gräben zu ätzen und an deren Boden die Versorgungsspannungsleitungen durch Implantation oder Diffusion zu erzeugen. Nachfolgend werden quer dazu die zweiten Gräben geöffnet. Anschließend werden die ersten Gräben und die zweiten Gräben mit isolierendem Material gefüllt. Das isolierende Material reicht dabei in etwa bis in die Höhe, in der die gemeinsamen Source-/Drain-Gebiete angeordnet sind. Durch Ausdiffusion aus einer Dotierstoffquelle, zum Beispiel aus dotiertem Glas, werden anschließend die gemeinsame Source-/Drain-Gebiete, die die Säulen ringförmig umgeben, gebildet.

Vorzugsweise werden die Gateelektroden des Speichertransistors und des Auswahltransistors sowie die Diodenstruktur unter Verwendung von Spacertechniken durch Abscheidung entsprechender Schichten und anisotropes Rückätzen dieser Schichten gebildet. Auf diese Weise können die Strukturen Abmessungen aufweisen, die kleiner sind als die in der jeweiligen Technologie minimal herstellbaren Strukturgröße F.

Es liegt im Rahmen der Erfindung, daß das Substrat mindestens im Bereich der Hauptfläche monokristallines Silizium aufweist. Als Substrat ist insbesondere eine monokristalline Siliziumscheibe oder eine monokristalline Siliziumschicht, die Teil eines Substrates ist, das auf einer Trägerscheibe eine isolierende Schicht und darauf die monokristalline Siliziumschicht aufweist, geeignet. Ferner liegt es im Rahmen der Erfindung, daß das Substrat im Bereich der Hauptfläche SiC aufweist.

Vorzugsweise wird die Diodenstruktur unter Verwendung unterschiedlich dotierter Siliziumschichten und/oder Metallsilizid erzeugt.

Im folgenden wird die Erfindung anhand von Ausführungsbeispielen, die in den Figuren dargestellt sind, näher erläutert.
- Figur 1: zeigt einen Schnitt durch ein p-dotiertes Substrat mit einer vergrabenen n⁺-dotierten Schicht und einer SiO₂-Schicht.
- Figur 2: zeigt den Schnitt durch das Substrat nach Bildung einer Hartmaske aus der SiO₂-Schicht und Bildung von Säulen.
- Figur 3: zeigt eine Aufsicht auf Figur 2.
- Figur 4: zeigt den in Figur 2 dargestellten Schnitt durch das Substrat nach Bildung eines dotierten Gebietes.
- Figur 5: zeigt den Schnitt durch das Substrat nach Bildung erster und zweiter Gräben zur Fertigstellung der Säulen.
- Figur 6: zeigt den Schnitt durch das Substrat nach Bildung eines Gatedielektrikums und erster dotierter Polysiliziumspacer.
- Figur 7: zeigt den Schnitt durch das Substrat nach Bildung einer Diffusionsbarriere und zweiter dotierter Polysiliziumspacer.
- Figur 8: zeigt den Schnitt durch das Substrat nach Bildung einer ersten Zwischenoxidschicht.
- Figur 9: zeigt den Schnitt durch das Substrat, nach Bildung leitender Strukturen, die an der Oberfläche der zweiten dotierten Polysiliziumspacer angeordnet sind.
- Figur 10: zeigt den Schnitt durch das Substrat nach Bildung einer zweiten Zwischenoxidschicht und einer leitfähigen Schicht.
- Figur 11: zeigt eine Aufsicht auf das Substrat nach Strukturierung der leitenden Schicht zur Bildung von Wortleitungssegmenten.
- Figur 12: zeigt den in Figur 10 dargestellten Schnitt des Substrats nach Bildung dritter dotierter Polysiliziumspacer.
- Figur 13: zeigt einen Schnitt durch ein Substrat, in dem eine gitterförmige Versorgungsspannungsleitung gebildet wurde.

Die Darstellungen in den Figuren sind nicht maßstäblich.

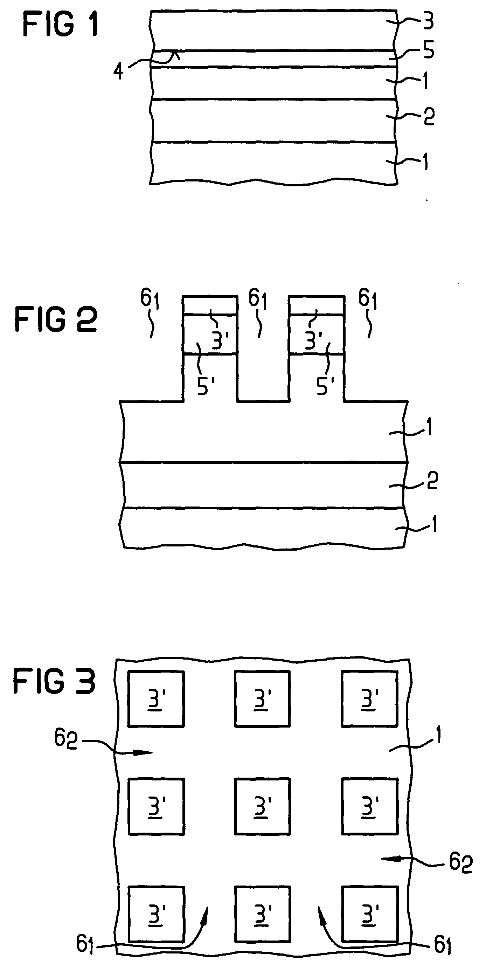

In einem Substrat 1 aus p-dotiertem, monokristallinem Silizium mit einer Grunddotierung von ca. 10¹⁶ cm⁻³ wird durch Implantation mit Arsen mit einer Dosis von ca. 10¹⁴ cm⁻² und einer Energie von ca. 2 MeV eine vergrabene n⁺-dotierte Schicht 2 in einer Tiefe von ca. 1 µm mit einer Dicke von ca. 0,2 µm erzeugt (siehe Figur 1). Alternativ kann als Substrat 1 ein n⁺-dotiertes Siliziumsubstrat, auf dessen Oberfläche eine p-dotierte Epitaxieschicht erzeugt ist, verwendet werden.

An eine Hauptfläche 4 angrenzend wird durch Implantation mit Arsen mit einer Dosis von 2 x 10¹⁵ cm⁻² und einer Energie von 200 keV eine n⁺-dotierte Schicht 5 in einer Dicke von ca. 0,1 µm gebildet.

Auf die Hauptfläche 4 des Substrats 1 wird nachfolgend zum Beispiel in einem TEOS-Verfahren eine SiO₂-Schicht 4 in einer Schichtdicke von ca. 200 nm abgeschieden. Unter Verwendung photolithographischer Prozeßschritte wird durch Strukturierung der SiO₂-Schicht 3 eine Hartmaske 3' gebildet (siehe Figur 2).

Die Hartmaske 3' weist quadratische massive Elemente auf, die rasterförmig angeordnet sind, die eine Kantenlänge von zum Beispiel 0,15 µm und einen gegenseitigen Abstand von zum Beispiel 0,15 µm aufweisen. Zwischen den massiven Elementen der Hartmaske 3' ist die Oberfläche der n⁺-dotierten Schicht 5 freigelegt. Durch die rasterförmige Anordnung der massiven Elemente der Hartmaske 3' verlaufen zwischen benachbarten massiven Elementen streifenförmige Maskengräben, wobei sich erste Maskengräben, die senkrecht zur zweiten Ebene parallel zur Hauptfläche 4 verlaufen, mit zweiten Maskengräben, die parallel zur zweiten Fläche außerhalb des dargestellten Schnitts verlaufen, schneiden.

Unter Verwendung der Hartmaske 3' als Ätzmaske werden erste Teilgräben 6₁ und zweite Teilgräben 6₂ geätzt. Die Ätzung erfolgt zum Beispiel mit HBr, Cl₂. Die Tiefe der Ätzung beträgt zum Beispiel 1,0 µm. Die Tiefe der Ätzung muß so groß sein, daß die ersten Teilgräben 6₁ und die zweiten Teilgräben 6₂ bis in das p-dotierte Substratmaterial 1 oberhalb der vergrabenen n⁺-dotierten Schicht 2 hineinreichen.

Bei der Ätzung der ersten Teilgräben 6₁ und der zweiten Teilgräben 6₂ wird die n⁺-dotierte Schicht 5 strukturiert. Dabei werden Source-/Drain-Gebiete 5' nachfolgend herzustellende Auswahltransistoren gebildet.

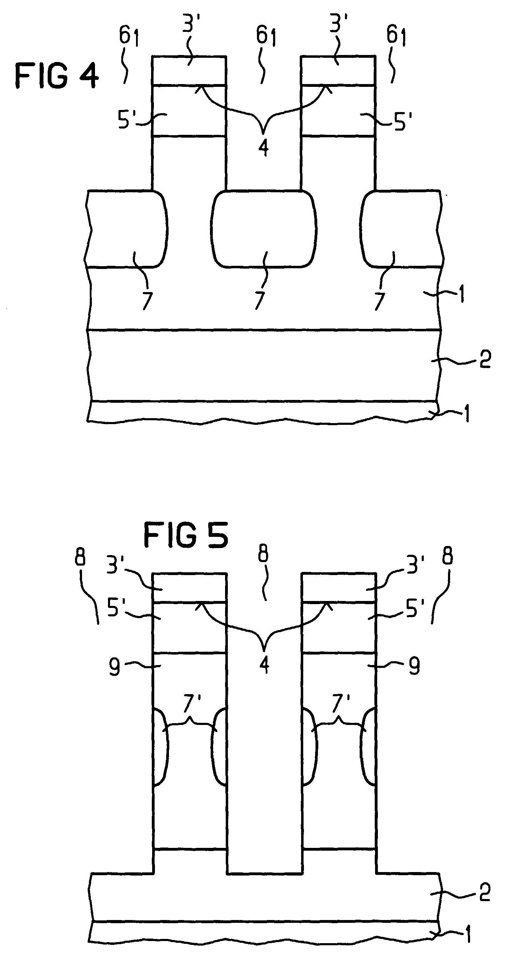

Durch Implantation mit Arsen oder Phosphor mit einer Dosis von 5 x 10¹⁵ cm⁻² und einer Energie von 50 keV und anschließendes Tempern wird am Boden der ersten Teilgräben 6₁ und der zweiten Teilgräben 6₂ ein dotiertes Gebiet 7 gebildet (siehe Figur 4). Entsprechend dem Verlauf der ersten Teilgräben 6₁ und der zweiten Teilgräben 6₂ weist das dotierte Gebiet 7 einen gitterförmigen Querschnitt parallel zur Hauptfläche 4 auf. Die Tiefe des dotierten Gebietes 7 beträgt nach Ausdiffusion durch nachfolgende Hochtemperaturschritte zum Beispiel ca. 0,1 µm. Sie wird so bemessen, daß das dotierte Gebiet 7 nicht bis auf die Oberfläche der vergrabenen n⁺-dotierten Schicht 2 reicht.

Um eine Dotierung der freiliegenden Seitenwände der ersten Teilgräben 6₁ und der zweiten Teilgräben 6₂ zu vermeiden, ist es vorteilhaft, diese Seitenwände mit ca. 20 nm dünnen SiO₂-Spacern, die durch Abscheidung einer 20 nm dicken SiO₂-Schicht und anisotropes Rückätzen gebildet werden, zu maskieren (nicht dargestellt).

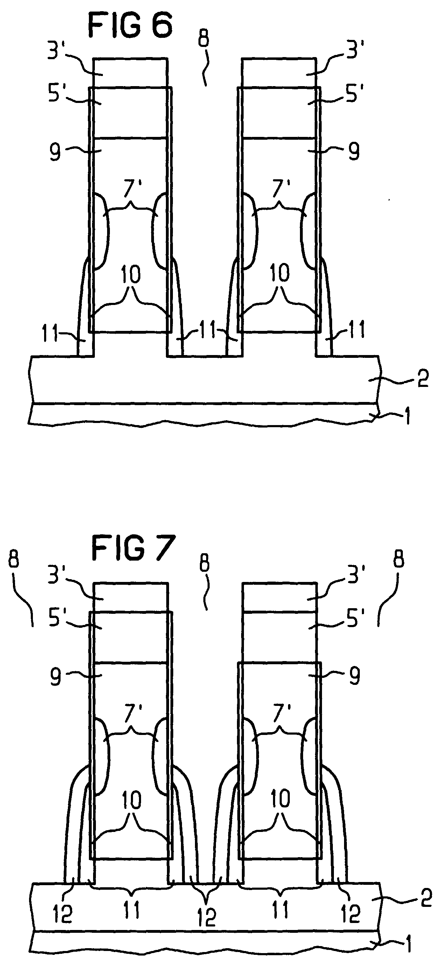

Durch anisotropes Ätzen mit Cl₂, HBr unter Verwendung der Hartmaske 3' als Ätzmaske werden aus den ersten Teilgräben 6₁ und den zweiten Teilgräben 6₂ erste Gräben 8 und zweite Gräben (in diesem Schnitt nicht sichtbar) gebildet, die von der Hauptfläche 4 bis in die vergrabene n⁺-dotierte Schicht 2 reichen (siehe Figur 5). Die Tiefe der ersten Gräben 8 und der zweiten Gräben beträgt etwa 1,0 µm. Dabei werden zwischen den ersten Gräben 8 und den quer dazu verlaufenden zweiten Gräben Siliziumsäulen 9 gebildet (siehe Figur 5). Bei der Bildung der Siliziumsäulen 9 wird das dotierte, gitterförmige Gebiet 7 strukturiert. Dabei entstehen an den Flanken der Siliziumsäulen 9 ringförmige gemeinsame Source-/Drain-Gebiete 7' (siehe Figur 5).

Durch thermische Oxidation wird ein erstes Gateoxid 10 in einer Dicke von zum Beispiel 5 nm gebildet (siehe Figur 6). Das erste Gateoxid 10 bedeckt mindestens die Flanken der Siliziumsäulen 9 zwischen dem gemeinsamen Source-/Drain-Gebiet 7' und der vergrabenen n⁺-dotierten Schicht 2.

Durch Abscheidung einer ersten leitfähigen Schicht aus in situ n⁺-dotiertem Polysilizium in einer Schichtdicke von zum Beispiel 30 nm und anschließendes anisotropes Rückätzen mit C₂F₆ werden erste dotierte Polysiliziumspacer 11 gebildet. Die ersten dotierten Polysiliziumspacer 11 bedecken den unteren Bereich der Flanken der Siliziumsäulen 9. Die ersten dotierten Polysiliziumspacer 11 reichen mindestens bis zu dem der vergrabenen n⁺-dotierten Schicht 2 zugewandten pn-Übergang des gemeinsamen Source-/Drain-Gebietes 7' mit dem p-dotierten Substratmaterial der Siliziumsäule 9. Der erste dotierte Polysiliziumspacer 11 umgibt die jeweilige Siliziumsäule 9 ringförmig. Er bildet die Gateelektrode eines Speichertransistors, der aus dem an die jeweilige Siliziumsäule 9 angrenzenden Teil der vergrabenen n⁺-dotierten Schicht 2 als Source-/Drain-Gebiet, dem gemeinsamen Source-/Drain-Gebiet 7' in der entsprechenden Siliziumsäule 9 und dem dazwischen angeordneten p-dotierten Silizium gebildet wird.

Auf die Oberfläche des ersten dotierten Polysiliziumspacers 11 wird nachfolgend eine dielektrische Schicht zum Beispiel aus SiO₂, nitridiertem SiO₂ oder Si₃N₄ in einer Schichtdicke von ca. 0,5 bis 1,5 µm aufgebracht. Der Übersichtlichkeit halber ist die dielektrische Schicht nicht dargestellt. Auf die dielektrische Schicht wird eine zweite leitfähige Schicht zum Beispiel aus in situ n-dotiertem Polysilizium abgeschieden und anisotrop rückgeätzt. Dadurch wird ein Zweiter dotierter Polysiliziumspacer 12 gebildet (siehe Figur 7). Der zweite dotierte Polysiliziumspacer 12 umgibt den ersten dotierten Polysiliziumspacer 11 ringförmig und bildet gemeinsam mit der dielektrischen Schicht und dem ersten dotierten Polysiliziumspacer 11 eine integrierte Diode mit unsymmetrischer Kennlinie. Dazu werden die Dotierstoffkonzentrationen im ersten dotierten Polysiliziumspacer 11 auf ca. 10²⁰ cm⁻³ und im zweiten dotierten Polysiliziumspacer 12 auf ca. 10¹⁷ cm⁻³ eingestellt.

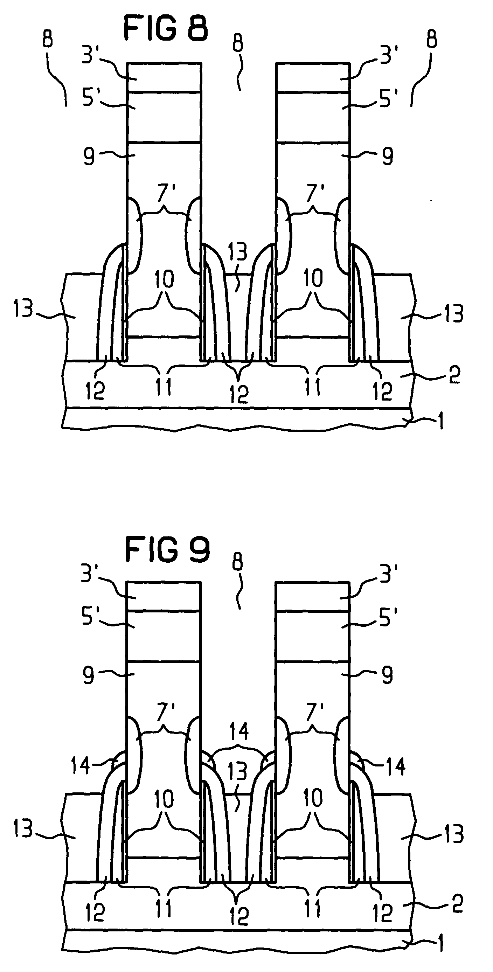

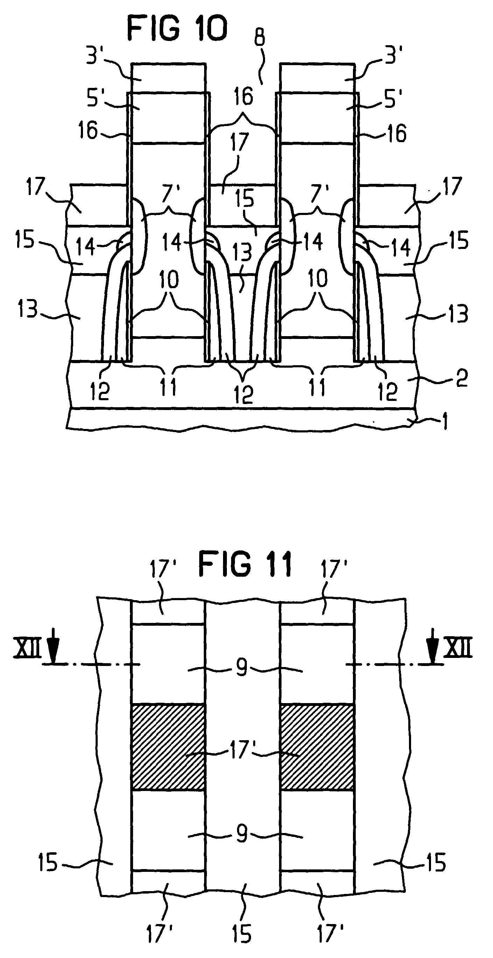

Durch Abscheidung von verfließbarem SiO₂ wird eine erste Zwischenoxidschicht 13 gebildet, die den unteren Bereich der ersten Gräben 8 und zweiten Gräben bis zur Höhe des gemeinsamen Source-/Drain-Gebietes 7' auffüllt. Die erste Zwischenoxidschicht 13 läßt dabei die Oberfläche des zweiten dotierten Polysiliziumspacers 12 teilweise unbedeckt (siehe Figur 8). Durch eine isotrope Ätzung zum Beispiel mit HF werden freiliegende Teile des ersten Gateoxids 10 entfernt. Anschließend wird ein silizidfähiges Metall, zum Beispiel Titan oder Wolfram, abgeschieden und silizidiert. Auf diese Weise entsteht an der Oberfläche der zweiten dotierten Polysiliziumspacer 12 eine leitfähige Struktur 14 aus Metallsilizid, die den zweiten dotierten Polysiliziumspacer 12 mit dem gemeinsamen Source-/Drain-Gebiet 7, verbindet (siehe Figur 9). Durch eine Dotierung der zweiten dotierten Polysiliziumspacer 12 von 10¹⁷ cm⁻³ und Verwendung von Titansilizid für die leitende Struktur 14 bildet diese mit dem zweiten dotierten Polysiliziumspacer eine Schottky-Diode. Diese wird gemeinsam mit der aus dem ersten dotierten Polysiliziumspacer 11 und dem zweiten dotierten Polysiliziumspacer 12 gebildeten Diode als Diodenstruktur verwendet. Alternativ kann die Schottky-Diode oder die aus dem ersten dotierten Polysiliziumspacer 11 und dem zweiten dotierten Polysiliziumspacer 12 gebildete Diode auch allein verwendet werden, wobei dann der zweite dotierte Polysiliziumspacer 12 vom p-Dotierungstyp ist.

Nachfolgend wird eine zweite Zwischenoxidschicht 15 durch Abscheidung von verfließbarem Oxid erzeugt, die die leitende Struktur 14 vollständig zudeckt (siehe Figur 10). Durch thermische Oxidation wird an den freiliegenden Flanken der Säulen 9 ein zweites Gateoxid 16 in einer Schichtdicke von zum Beispiel 5 nm gebildet.

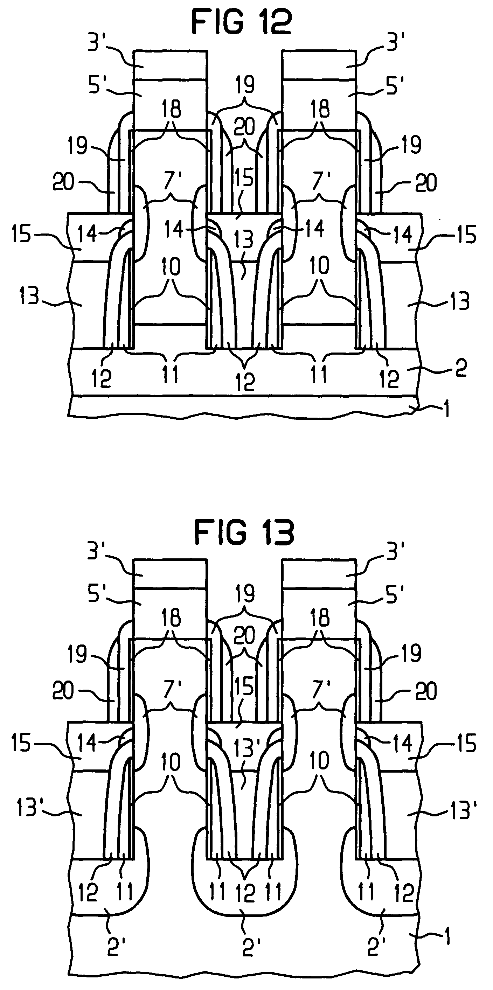

Nachfolgend wird eine leitende Schicht 17 in einer Schichtdicke von zum Beispiel 100 nm zum Beispiel aus in situ dotiertem n⁺-dotiertem Polysilizium abgeschieden (siehe Figur 10). Durch Rückätzen und Strukturierung der leitenden Schicht 17 werden zwischen benachbarten Siliziumsäulen 9 Wortleitungssegmente 17' erzeugt (siehe Aufsicht in Figur 11). Die Wortleitungssegmente 17' bilden mit den daran angrenzenden Siliziumsäulen 9 jeweils parallele streifenförmige Gebilde, die voneinander beabstandet sind. Zwischen benachbarten streifenförmigen Gebilden, die jeweils aus den Wortleitungssegmenten 17' und den zugehörigen Siliziumsäulen 9 gebildet werden, liegt die Oberfläche der zweiten Zwischenoxidschicht 15 frei.

Durch isotropes Ätzen zum Beispiel mit HF werden freiliegende Teile des zweiten Gateoxids 16 entfernt. Es wird eine thermische Oxidation durchgeführt, bei der an freiliegenden Siliziumoberflächen ein drittes Gateoxid 18 gebildet wird. Das dritte Gateoxid 18 wird einer Dicke von zum Beispiel 5 nm gebildet. Anschließend wird eine leitfähige Schicht aus zum Beispiel in situ n⁺-dotiertem Polysilizium abgeschieden und durch anisotropes Rückätzen strukturiert. Dabei wird ein dritter dotierter Polysiliziumspacer 19 gebildet, der die jeweilige Siliziumsäule 9 ringförmig umgibt (siehe Figur 12). Der dritte dotierte Polysiliziumspacer 19 bildet eine Gateelektrode für den Auslesetransistor, der aus dem gemeinsamen Source-/Drain-Gebiet 7', dem p-dotierten Silizium der Siliziumsäule 9 und dem Source-/Drain-Gebiet 5' gebildet wird. Die dritten dotierten Polysiliziumspacer sind an der Oberfläche der Wortleitungssegmente 17' angeordnet.

Eine leitfähige Verbindung mit diesen wird hergestellt, indem mit einer isotropen Ätzung unter Verwendung von HF das dritte Gateoxid 18 auf der freiliegenden Oberfläche der Wortleitungssegmente 17' entfernt wird und anschließend eine in situ n⁺-dotierte Polysiliziumschicht von ca. 30 nm Dicke abgeschieden wird. Mit einer Spacerätzung werden vierte Polysiliziumspacer 20 gebildet, die die Wortleitungssegmente 17' leitend mit den dritten Polysiliziumspacern 19 verbinden. Die dritten dotierten Polysiliziumspacer 19 bilden gemeinsam mit den Wortleitungssegmenten 17' die Wortleitungen.

Die Speicherzellenanordnung wird durch Abscheidung eines weiteren Zwischenoxids, durch Kontaktlochätzung für den Bitleitungsanschluß zu den Source-/Drain-Gebieten 5', durch Bildung von Bitleitungen, Metallisierungen und Passivierungsschichten in bekannter Weise fertiggestellt (nicht im einzelnen dargestellt).

In einem weiteren Ausführungsbeispiel wird die Prozeßfolge, wie sie anhand der Figuren 1 bis 5 geschildert wurde, durchgeführt, wobei jedoch die Bildung der vergrabenen, n⁺-dotierten Schicht 2 nicht erfolgt. Nach dem in Figur 5 erreichten Prozeßstand wird eine Implantation mit Arsen mit einer Dosis von zum Beispiel 10¹⁵ cm⁻² und einer Energie von zum Beispiel 30 keV durchgeführt, um am Boden der ersten Gräben 8 und der zweiten Gräben ein gitterförmiges n⁺-dotiertes Gebiet 2' zu bilden (siehe Figur 13, in der gleiche Teile wie im ersten Ausführungsbeispiel mit den gleichen Bezugszeichen bezeichnet sind). Benachbarte Stege des gitterförmigen n⁺-dotierten Gebietes 2' sind so bemessen, daß zwischen ihnen p-dotiertes Silizium des Substrats 1 angeordnet ist.

Anschließend werden die Prozeßschritte wie anhand von Figur 6 und 7 erläutert, durchgeführt. Nach Bildung der zweiten dotierten Polysiliziumspacer 12 wird eine thermische Oxidation durchgeführt zur Bildung einer dünnen SiO₂-Schicht an der Oberfläche der zweiten dotierten Polysiliziumspacer 12 (nicht dargestellt). Die SiO₂-Schicht weist eine Dicke von etwa 5 nm auf. Anschließend wird eine leitfähige Füllung durch Abscheidung von in situ dotiertem Polysilizium und Rückätzen des Polysiliziums gebildet, die den Boden der ersten Gräben 8 und zweiten Gräben auffüllt und die maximal bis zur Höhe der zweiten dotierten Spacer 12 reicht. Die leitende Füllung 13' bildet mit dem zweiten dotierten Polysiliziumspacer 12 eine zusätzliche Kapazität, die die Kapazität der Gesamtanordnung zur Speicherung der die Information darstellende Ladung erhöht. Die leitende Füllung 13' kann kontaktiert werden (nicht dargestellt) und mit einem definierten Potential beaufschlagt werden.

Die Speicherzellenanordnung wird nachfolgend wie anhand von Figur 9 bis 12 beschrieben fertiggestellt.

## Patentansprüche

1. DRAM-Zellenanordnung,
- bei der in einem Substrat (1) integriert eine Vielzahl dynamischer selbstverstärkender Speicherzellen vorgesehen sind,
- bei der jede Speicherzelle einen Auswahltransistor, einen Speichertransistor und eine Diodenstruktur aufweist,
- bei der der Auswahltransistor und der Speichertransistor jeweils als in Bezug auf eine Hauptfläche des Substrats vertikale MOS-Transistoren ausgebildet sind,
- bei der der Auswahltransistor und der Speichertransistor übereinander angeordnet und über ein gemeinsames Source-/Drain-Gebiet (7') miteinander verbunden sind,
- bei der ein Source-/Drain-Gebiet (2) des Speichertransistors mit einer Versorgungsspannungsleitung, ein Source-/Drain-Gebiet (5') des Auswahltransistors mit einer Bitleitung und die Gateelektrode (19) des Auswahltransistors mit einer Wortleitung (17', 19) verbunden ist und die Diodenstruktur (11, 12, 14) zwischen das gemeinsame Source-/Drain-Gebiet (7') und die Gateelektrode (11) des Speichertransistors geschaltet ist.

2. DRAM-Zellenanordnung nach Anspruch 1,
- bei der das Substrat (1) Säulen (9) aufweist, die senkrecht zur Hauptfläche (4) des Substrats angeordnet sind,
- bei der der Auswahltransistor und der Speichertransistor jeweils an den Flanken einer der Säulen (9) angeordnet sind, wobei die Gateelektroden (11, 19) des Auswahltransistors und des Speichertransistors und die Diodenstruktur (12, 14) die Säule (9) ringförmig umgeben.

3. DRAM-Zellenanordnung nach Anspruch 2,
- bei der die Versorgungsspannungsleitung (2) mindestens teilweise im Substrat (1) unterhalb der Säule (9) verläuft,
- bei der die Wortleitung Segmente (17') aufweist, die zwischen benachbarten Säulen (9) angeordnet sind und die mit den diese Säulen (9) umgebenden Gateelektroden (19) der Auswahltransistoren verbunden sind,
- bei der die Diodenstruktur (11, 12, 14) jeweils unterhalb der Wortleitung angeordnet ist.

4. DRAM-Zellenanordnung nach einem der Ansprüche 1 bis 3, bei der die Diodenstruktur eine np-Diode und/oder eine Schottky-Diode und/oder eine Dünnschichtdiode aufweist.

5. DRAM-Zellenanordnung nach einem der Ansprüche 1 bis 4, bei der zwichen den Diodenstrukturen (11, 12, 14) benachbarter Säulen (9) eine zusätzliche leitende Struktur (13') angeordnet ist, die gemeinsam mit der daran angrenzenden Oberfläche der Diodenstruktur (12) eine zusätzliche Kapazität bildet.

6. Verfahren zur Herstellung einer dynamischen, selbstverstärkenden Speicherzellenanordnung,
- bei dem in einem Substrat (1) eine Vielzahl dynamischer selbstverstärkender Speicherzellen erzeugt werden, die jeweils einen Auswahltransistor, einen Speichertransistor und eine Diodenstruktur aufweisen,
- bei dem der Auswahltransistor und der Speichertransistor jeweils als im Bezug auf eine Hauptfläche (4) des Substrats (1) vertikale MOS-Transistoren gebildet werden,
- bei dem der Auswahltransistor und der Speichertransistor übereinander angeordnet und über ein gemeinsames Source-/Drain-Gebiet (7') miteinander verbunden werden,
- bei dem ein Source-/Drain-Gebiet (2) des Speichertransistors mit einer Versorgungsspannungsleitung, ein Source-/Drain-Gebiet (5') des Auswahltransistors mit einer Bitleitung und die Gateelektrode (19) des Auswahltransistors mit einer Wortleitung (17', 19) verbunden wird und die Diodenstruktur (11, 12, 14) zwischen das gemeinsame Source-/Drain-Gebiet (7') und die Gateelektrode (11) des Speichertransistors geschaltet wird.

7. Verfahren nach Anspruch 6,
- bei dem das Substrat (1) mit Säulen (9) versehen wird, die senkrecht zur Hauptfläche (4) des Substrats (1) angeordnet sind,
- bei dem der Auswahltransistor und der Speichertransistors jeweils an den Flanken einer der Säulen (9) gebildet werden, wobei die Gateelektroden (19) des Auswahltransistors und des Speichertransistors und die Diodenstruktur (11, 12, 14) die Säule (9) ringförmig umgeben.

8. Verfahren nach Anspruch 7,
- bei dem zur Bildung der Säulen in der Hauptfläche (4) erste Gräben (8) und zweite Gräben geätzt werden, wobei die ersten Gräben und die zweiten Gräben jeweils streifenförmig sind und im wesentlichen parallel zueinander verlaufen und die ersten Gräben (8) die Zweiten Gräben kreuzen,
- bei dem an der Hauptfläche (4) jeweils das mit der Bitleitung verbundene Source-/Drain-Gebiet (5') des Auswahltransistors, am Boden der Säule (9) das mit der Versorgungsspannungsleitung verbundene Source-/Drain-Gebiet (2) des Speichertransistors und dazwischen an den Flanken der Säule (9) das gemeinsame Source-/Drain-Gebiet (7') in Form eines ringförmigen dotierten Gebietes gebildet wird.

9. Verfahren nach Anspruch 8,
- bei dem zur Bildung der Säulen (9) zunächst erste und zweite Teilgräben (6₁, 6₂) geätzt werden, deren Verlauf dem der ersten Gräben (8) und der zweiten Gräben entspricht, deren Tiefe jedoch geringer als die der ersten Gräben (8) und der zweiten Gräben ist,
- bei dem am Boden der ersten Teilgräben (6₁) und der zweiten Teilgräben (6₂) ein dotiertes Gebiet (7) erzeugt wird,
- bei dem durch weiteres Ätzen aus den ersten Teilgräben (6₁) und den zweiten Teilgräben (6₂) die ersten und zweiten Gräben (8) erzeugt werden, wobei durch Strukturieren des dotierten Gebietes (7) am Boden der ersten Teilgräben (6₁) und der zweiten Teilgräben (6₂) jeweils das gemeinsame Source-/Drain-Gebiet (7') erzeugt wird.

10. Verfahren nach Anspruch 9,
bei dem nach der Bildung der Säulen (9) die Versorgungsspannungsleitung (2') am Boden der ersten Gräben (8) und der zweiten Gräben als gitterförmiges dotiertes Gebiet erzeugt wird.

11. Verfahren nach einem der Ansprüche 7 bis 10,
- bei dem zur Bildung der Gateelektrode (11) des Speichertransistors und der Diodenstruktur (12) eine erste dotierte Schicht mit im wesentlichen konformer Kantenbedeckung abgeschieden und anisotrop rückgeätzt wird, wobei ein erster dotierter Spacer (11) entsteht,
- bei dem eine zweite dotierte Schicht mit im wesentlichen konformer Kantenbedeckung abgeschieden und anisotrop rückgeätzt wird, wobei ein zweiter dotierter Spacer (12) entsteht,
- bei dem eine leitende Struktur (14) gebildet wird, die teilweise an der Oberfläche des zweiten dotierten Spacers (12) angeordnet ist und die mit dem gemeinsamen Source-/Drain-Gebiet (7') verbunden ist.

12. Verfahren nach Anspruch 11,
bei dem zwischen an benachbarten Säulen (9) angeordneten zweiten dotierten Spacern (12) eine dotierte Füllung (13') gebildet wird, die mit dem zweiten dotierten Spacer eine zusätzliche Kapazität bildet.

13. Verfahren nach Anspruch 11 oder 12,
- bei dem das Substrat (1) mindestens im Bereich der Hauptfläche (4) monokristallines Silizium aufweist,
- bei dem die erste dotierte Schicht und die zweite dotierte Schicht dotiertes Silizium enthalten,
- bei dem die leitende Struktur (14) Metallsilizid enthält.
